# FASCICULE DE BREVET EUROPEEN

(11) **EP 3 255 334 B1**
(45) Date de publication et mention de la délivrance du brevet: **02.09.2020**
(21) Numéro de dépôt: 17174296.8
(22) Date de dépôt: 02.06.2017
(51) Int. Cl.: H05K 1/02, H05K 9/00, F21S 41/19, F21S 41/20, F21S 45/10, F21S 43/14, F21S 45/47

(54) **DISPOSITIF LUMINEUX POUR UN VÉHICULE AUTOMOBILE INTÉGRANT DES MOYENS DE PROTECTION CONTRE DES DÉCHARGES ÉLECTROSTATIQUES**
LEUCHTVORRICHTUNG FÜR KRAFTFAHRZEUGE MIT INTEGRIERTEM SCHUTZ GEGEN ELEKTROSTATISCHE ENTLADUNG
LIGHTING DEVICE FOR A MOTOR VEHICLE HAVING INTEGRATED MEANS FOR PROTECTION AGAINST ELECTROSTATIC DISCHARGES

(30) Priorité: 09.06.2016 FR 1655313
(43) Date de publication de la demande: 13.12.2017
(73) Titulaire: Valeo Vision, 93012 Bobigny Cedex (FR)
(72) Inventeur: ROGER, Christophe, 49000 ANGERS (FR); JOBARD, Jérome, 49000 ANGERS (FR); PLACAIS, Pierre, 49000 ANGERS (FR)

(56) Documents cités:
- DE-A1-102010 040 558
- DE-U1-202007 011 255

## Description

L'invention a trait au domaine des dispositifs lumineux pour un véhicule automobile. L'invention concerne en particulier de tels dispositifs faisant intervenir des composants électroniques sensibles à des décharges électrostatiques, tels que par exemple des diodes électroluminescentes.

Dans le domaine des dispositifs lumineux pour véhicules automobiles, l'utilisation de sources lumineuses telles que des diodes électroluminescentes, LEDs, de diodes électroluminescentes organiques, OLED, ou diodes laser est de plus en plus préconisé. Le placement de ces moyens lumineux le long de contours précis permet en effet de créer des signatures optiques intéressantes et individuelles. Cependant, il s'agit de composants électroniques sensibles, notamment à des décharges électrostatiques. Lors du cycle de vie d'un véhicule automobile, de tels composants peuvent être exposés à des décharges électrostatiques à l'intérieur du projecteur dont ils font partie. Par exemple, par frottement de l'air extérieur sur les glaces d'un projecteur, des parties de celles-ci peuvent devenir porteuses de charges statiques. Lorsque les sources lumineuses sont soumises à des décharges provenant de ces pièces, il existe un fort risque de dégradation voir de destruction prématurés des composants électroniques.

Afin de protéger des sources lumineuses, il est connu de prévoir des circuits électroniques de protection dans le dispositif lumineux. Il peut par exemple s'agir d'une capacité électrique montée en parallèle d'une LED, la capacité étant apte à absorber une surcharge éventuelle. Cependant, le coût d'une telle solution augmente proportionnellement avec le nombre de LEDs utilisés. En plus, de tels circuits de protection occupent une partie importante sur les circuits imprimés respectifs, tandis que l'espace au sein du dispositif est restreint.

Le document de brevet US 2002/0151200 A1 décrit un élément circuit de protection d'un dispositif électronique par rapport à des surcharges qui interviennent au sein du circuit électronique comprenant un composant sensible. Un tel système ne peut être utile que si la surcharge ne peut se produire qu'à un endroit prédéfini du circuit à protéger. Des moyens aptes à rediriger la surcharge vers la masse en amont du composant sensible peuvent alors être intégrés au circuit à protéger. Une telle solution n'est pourtant pas applicable à des cas tels que décrits, dans lesquels une décharge électrostatique peut avoir lieu de manière aléatoire vers un circuit électronique comportant un ou plusieurs composants sensibles. Comme la décharge peut se réaliser sur différentes parties du circuit à protéger, cette solution connue ne permet pas la résolution du problème décrit. Le document DE 20 2007 011 255 U1 décrit un dispositif lumineux connu.

L'invention a pour objectif de pallier à au moins un des problèmes posés par l'art antérieur. Plus précisément, l'invention a pour objectif de proposer un dispositif lumineux ayant une protection intégrée des composants électroniques sensibles à une décharge électrostatique.

L'invention a pour objet un dispositif lumineux pour un véhicule automobile. Le dispositif comprend un substrat sur lequel est arrangé au moins un élément d'un circuit électronique. Le circuit électronique comprend au moins un composant électronique sensible à une décharge électrostatique. Le dispositif comprend également une structure qui est distincte du substrat, susceptible de porter des charges électriques. La plus petite distance entre la structure et chacun des éléments du circuit est égale à D1. Le dispositif comprend en outre un moyen électriquement conducteur relié électriquement à la masse, c'est-à-dire au potentiel de référence zéro. Le dispositif est remarquable en ce qu'il comprend au moins un élément protecteur contre les décharges électrostatiques disposé sur ladite structure et relié électriquement à celle-ci, la plus petite distance entre l'élément protecteur et le moyen électriquement conducteur, D2, étant inférieure à D1 et non-nulle, sans contact physique entre l'élément protecteur et le moyen électriquement conducteur relié à la masse.

De préférence, l'élément protecteur peut être agencé de sorte à ce que la distance entre l'élément protecteur et le composant électronique sensible soit supérieure à la distance entre l'élément protecteur et l'élément électriquement conducteur relié à la masse, de sorte à ce qu'il n'y a ait pas d'écoulement de charges depuis l'élément protecteur vers le composant à protéger.

De préférence, l'élément protecteur se situe sur une surface de ladite structure, ladite structure étant orientée vers ledit substrat.

De préférence la distance D2 peut être strictement inférieure à 10 mm, tandis que la distance D1 peut être strictement supérieure à 10 mm.

De préférence, les éléments du circuit électronique peuvent comprendre des pistes électriquement conductrices et des composants électroniques connectés aux pistes.

L'élément protecteur peut de préférence être un élément en matière plastique, au moins une partie de sa surface étant revêtue d'une couche électriquement conductrice. Il peut par exemple s'agir d'une couche de cuivre, d'aluminium ou d'un alliage métallique comprenant un métal électriquement conducteur.

De préférence, l'élément protecteur peut présenter une base et s'étend à partir de cette base, située au niveau de ladite structure, en s'amincissant pour former une pointe dirigée vers ledit moyen électriquement conducteur relié à la masse.

Le moyen électriquement conducteur peut de préférence comprendre une zone du substrat.

De préférence, le dispositif peut comprendre une pièce métallique distincte du substrat, par exemple un moyen de dissipation de chaleur tel qu'un radiateur, dont ledit moyen électriquement conducteur fait partie.

Le moyen électriquement conducteur peut être une zone de la surface du substrat ou de ladite pièce métallique.

L'élément protecteur peut de préférence comprendre un matériau métallique, électriquement conducteur.

De préférence, l'élément protecteur peut être venu de matière avec ladite structure. L'élément protecteur peut préférentiellement être réalisé par déformation, notamment locale, de la structure, par exemple à un endroit situé au droit du moyen électriquement conducteur relié à la masse.

L'élément protecteur peut de préférence être une pièce qui est solidarisée avec ladite structure. La pièce peut de préférence être fixée à la structure par vissage ou par collage.

L'élément protecteur peut de préférence être réalisé ou fixé sur une zone dépourvue de rôle optique et/ou esthétique de ladite structure.

Le substrat peut de préférence être le substrat d'un circuit imprimé, PCB. Le substrat peut de préférence être plan.

Alternativement, le substrat peut être le substrat d'un dispositif d'interconnexion, MID, à géométrie complexe. Le substrat du dispositif d'interconnexion peut être moulé ou usiné.

De préférence, le composant électronique peut être une diode électroluminescente, LED, une diode laser, ou une diode électroluminescente organique, OLED. De manière préférée, le circuit électronique peut comprendre une pluralité de LEDs, de OLEDs ou de diodes laser sensibles à des décharges électrostatiques.

Le circuit électrique peut comprendre un groupe comprenant une pluralité de composants électroniques sensibles aux décharges électrostatiques, les composants électroniques de ce groupe étant connectés entre eux. Dans ce cas, le dispositif peut comporter un élément protecteur associé à ce groupe et qui est seul agencé pour protéger tous les composants électroniques de ce groupe.

De manière préférentielle, le circuit électrique peut comprendre une pluralité de groupes comprenant chacun une pluralité de composants électroniques sensibles aux décharges électrostatiques, les composants électroniques de chaque groupe étant connectés entre eux. Dans ce cas, le dispositif peut comporter une pluralité d'éléments protecteurs, chaque élément protecteur étant bijectivement associé à l'un des groupes et étant seul agencé pour protéger tous les composants électroniques de ce groupe.

La structure susceptible de porter des charges électriques peut de préférence être un élément de la glace du dispositif lumineux. Il peut notamment s'agir d'une pièce plastique métallisée et susceptible de porter des charges électriques. La pièce peut de préférence être aluminée.

De préférence, le dispositif peut être un projecteur ou un feu arrière d'un véhicule automobile.

Par rapport à des solutions connues, l'effet « paratonnerre » obtenu par les dispositions de la présente invention, permet de réduire les coûts de production d'un dispositif lumineux pour un véhicule automobile, tout en assurant une protection des composants électroniques sensibles à des décharges électrostatiques de manière durable. Les mesures de l'invention définissent un chemin de faible impédance entre la structure susceptible d'être chargée, moyennant l'élément de protection qui y est relié, et une zone électriquement reliée à la masse, favorisant ainsi la création d'arcs de décharge entre l'élément de protection d'une part et la zone reliée à la masse d'autre part. En effet, comme la distance D2 définie selon l'invention est inférieure à la distance D1, le dispositif favorise une décharge électrostatique entre l'élément de protection qui est électriquement relié à la structure susceptible de porter des charges électriques, et la zone reliée à la masse, par rapport aux éléments du circuit électronique. La longévité des composants électroniques et du dispositif sont donc accrues et la complexité des circuits électroniques impliqués est en même temps réduite par rapport à des solutions connues. En effet, en appliquant l'invention proposée, on peut s'affranchir de circuits de protection dédiés impliquant une capacité pour chacune des sources lumineuses d'un tel dispositif. Ceci est particulièrement intéressant lorsqu'un nombre important de telles sources lumineuses, comme par exemple des LEDs, est utilisé dans un dispositif lumineux afin d'obtenir une signature optique particulière. Un ou plusieurs éléments de protection, faciles à réaliser, et positionnés selon les dispositions de l'invention sont capables de protéger une pluralité de telles sources lumineuses contre des décharges électrostatiques aléatoires provenant par exemple de charges accumulées sur une face d'une glace du dispositif.

D'autres caractéristiques et avantages de la présente invention seront mieux compris à l'aide de la description exemplaire et des dessins parmi lesquels :
- la figure 1 illustre de manière schématique une coupe latérale d'un mode de réalisation préférentiel du dispositif selon l'invention ;
- la figure 2 illustre de manière schématique une coupe latérale d'un mode de réalisation préférentiel du dispositif selon l'invention ;
- la figure 3 illustre de manière schématique une coupe latérale d'un mode de réalisation préférentiel du dispositif selon l'invention.

Dans la description qui suit, des numéros de référence similaires seront utilisés pour décrire des concepts similaires à travers des modes de réalisation différents de l'invention. Ainsi, les numéros 100, 200, 300 décrivent un dispositif selon l'invention dans trois modes de réalisation différents.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif.

Dans la description suivante, des composants nécessaires au fonctionnement d'un dispositif lumineux pour un véhicule automobile, mais qui n'ont pas d'impact direct par rapport à la présente invention, ne seront pas décrits de manière explicite afin de maintenir la clarté de l'exposé de l'invention. De manière connue, les sources lumineuses d'un dispositif lumineux pour un véhicule automobile sont alimentées par une source de courant interne au véhicule, tel que la batterie du véhicule, et par le biais d'un dispositif de pilotage de l'alimentation comprenant en général au moins un convertisseur. Des convertisseurs adaptés sont en soi connus dans l'état de l'art et sont aptes à convertir une tension continue d'entrée en une tension continue de sortie différente, adaptée à l'alimentation de la ou des sources lumineuses du dispositif. Un dispositif lumineux peut également comprendre de manière connue des moyens optiques destinés à guider les rayons lumineux émis par la ou les sources lumineuses du dispositif. Il peut par exemple s'agir de lentilles optiques et/ou de guides d'ondes. Un dispositif selon l'invention peut en outre réaliser une ou plusieurs fonctions lumineuses du véhicule automobile dans lequel il est installé. Il peut par exemple s'agir de manière non limitative des fonctions feux diurnes, feux de route ou indicateur de direction.

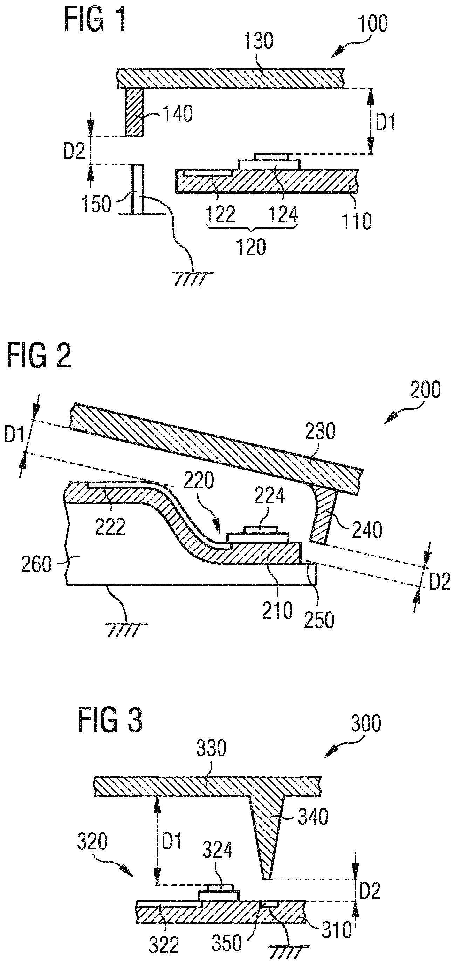

La figure 1 montre une illustration schématique des éléments d'un dispositif 100 selon un mode de réalisation préférentiel de l'invention. Le dispositif comprend un substrat 110 qui supporte un circuit électronique 120. Il peut par exemple s'agir d'une carte de circuit imprimée généralement plane, PCB (« printed circuit board »), ou d'autres substrats en soi connus dans l'art. Le circuit électronique 120 comprend des pistes conductrices 122 et des composants 124 reliés par les pistes conductrices. A titre d'exemple non limitatif, une diode électroluminescente 124, LED, est illustrée. Bien que le substrat illustré ne supporte qu'un seul circuit, il peut également comprendre plusieurs circuits disjoints réalisant des fonctions différentes. La formation de pistes conductrices sur un substrat et la fixation des composants sur le substrat sont en soi connues dans l'art et ne seront pas décrites de manière détaillée dans le cadre de la présente invention.

Le dispositif comprend également une structure 130 qui est susceptible de porter, au moins de manière temporaire, des charges électriques. Il s'agit par exemple d'un élément de la glace du dispositif lumineux, qui peut se charger électriquement lors de la conduite du véhicule par frottement avec l'air extérieur. Il peut également s'agir d'un enjoliveur du dispositif. Dans l'illustration de la figure 1, la structure 130 est montrée comme étant plane. La structure peut néanmoins présenter des géométries différentes et plus complexes. Par exemple, la structure peut avoir une géométrie courbe selon au moins une direction. La plus petite distance entre le substrat qui supporte le circuit 120 et la structure 130 est indiquée par la mesure D1. La distance en question est considérée entre tous les points de la surface de la structure et tous les points du circuit à protéger.

Afin d'éviter qu'une charge présente sur la structure 130 ne vienne se décharger sur un des éléments 122, 124 du circuit électronique 120, ce qui engendrerait un endommagement des composants 124, un élément protecteur ou élément de protection 140 et un moyen électriquement conducteur 150 sont prévus. L'élément de protection 140 a pour unique fonction la protection du circuit électronique 120 à l'encontre de décharges électrostatiques.

L'élément protecteur 140 peut être venu de matière avec la structure 130 qui est de préférence en plastique et dont au moins la surface dirigée vers le substrat 110 est aluminée ou métallisée. L'élément protecteur 140 peut notamment être le résultat d'une déformation locale de la structure 130. L'élément protecteur est disposé de façon à ne pas porter préjudice à des fonctions optiques ou esthétiques de la structure 130. Dans le cas illustré, il s'agit d'une pièce séparée reliée de manière électriquement conductrice à la structure 130, de manière à ce que des charges électriques statiques accumulées sur la structure 130 puissent migrer vers l'élément protecteur 140. La fixation est réalisée par collage, par vissage ou par d'autres moyens adaptés.

L'élément protecteur s'étend depuis la surface de la structure 130 qui est dirigée vers le substrat 110 vers un élément électriquement conducteur 150, qui est relié à la masse. La disposition de l'élément protecteur 140 et de cet élément 150 relié à la masse est telle que la distance D2 qui les sépare est non nulle et strictement inférieure à la distance D1. A titre exemplaire, la distance D2 est strictement inférieure à 10 mm, tandis que la distance D1 est strictement supérieure à 10 mm. Evidemment, ce dimensionnement n'est par limitatif par rapport aux dispositions de l'invention. Une charge électrique de la structure 130 cherche le chemin de moindre impédance pour s'évacuer. En utilisant les dispositions de l'invention, ce chemin comprend l'élément de protection 140 et la zone 150 qui est électriquement connectée au potentiel zéro ou à la masse. Une charge électrique de la structure se décharge donc par un arc électrique entre la structure 130, par le biais de l'élément protecteur 140, et la zone 150, d'où elle est évacuée vers la masse. Une telle décharge est donc déviée du circuit 120 sans passer par les composants 124 ou les pistes conductrices 122. La protection du circuit 120 est ainsi assurée sans l'ajout de composants électroniques supplémentaires dans le circuit.

L'invention s'applique de manière analogue à des géométries plus complexes, à la fois au niveau de la structure potentiellement porteuse de charges et au niveau du substrat supportant le circuit électronique à protéger. Un exemple est illustré par la coupe de la figure 2, dans lequel le circuit 220 comprenant des pistes conductrices et une LED 224 fait partie d'un substrat 210 de type MID (« molded interconnect device ») ou dispositif d'interconnexion moulé ou usiné. La production de tels dispositifs est en soi connue dans l'art, et elle permet notamment de réaliser des circuits électroniques sur des substrats à géométrie complexe. Le dispositif 200 illustré comprend des moyens de dissipation thermique 260, tels qu'un radiateur métallique. Les moyens de dissipation thermique sont reliés à la masse et sont aptes à dissiper la chaleur produite par les composants du circuit électronique 220. Dans l'exemple montré, l'élément de protection 240 est fixé à la structure 230 porteuse de charges et s'étend en direction d'une zone de surface 250 du radiateur métallique 260 qui est relié à la masse. A titre alternatif, on peut également prévoir un élément en plastique dont la surface est au moins partiellement métallisée, le revêtement métallique étant relié à la masse, afin d'implémenter l'élément conducteur 250. Des charges électriques accumulées sur la structure 230 sont donc évacuées vers la masse en transitant par l'élément de protection 240 et l'élément conducteur 250.

Le mode de réalisation illustré par le dessin schématique de la figure 3 est semblable à la disposition montrée par la figure 1. Néanmoins, l'élément de protection 340 est venu de matière avec la structure 330. L'élément de protection a une forme de picot ayant une base élargie et s'amincissant en s'éloignant de la structure 330, afin de former une pointe dirigée vers la zone conductrice 350 reliée à la masse. La zone 350 est dans ce mode de réalisation formée par une plage conductrice sur le substrat 310 qui porte le circuit électronique à protéger. La distance D2 entre la pointe de l'élément 350, qui présente une concentration de charges électriques statiques, et la zone 350 est inférieure à la distance D1 telle que définie préalablement, de manière à ce que les charges accumulées dans la pointe s'écoulent par formation d'un arc entre la point et la zone 350, sans passer par les composants du circuit électronique 320.

Bien que dans les modes de réalisation exemplaires qui viennent d'être décrits, un seul élément protecteur 130, 230, 330 soit illustré, plusieurs éléments similaires peuvent être disposés selon la manière qui vient d'être décrite. Il va de soi que le ou les éléments protecteurs sont aptes à protéger tout circuit électronique disposé sur un ou plusieurs substrats, à condition que la distance D2 telle qu'elle a été définie soit inférieure à la plus petite distance entre la structure susceptible d'être chargée et chacun des éléments de chacun des circuits à protéger.

En se basant sur la description qui vient d'être donnée et les figures accompagnatrices, l'application de l'invention à des géométries plus complexes sera à la portée de l'homme du métier ayant des connaissances générales dans le domaine.

## Revendications

1. Dispositif lumineux (100, 200, 300) pour un véhicule automobile comprenant un substrat (110, 210, 310) sur lequel est arrangé au moins un élément (122, 124 ; 222, 224 ; 322, 324) d'un circuit électronique (120, 220, 320) comprenant au moins un composant électronique sensible à une décharge électrostatique, et
une structure qui est distincte du substrat (130, 230, 330) susceptible de porter des charges électriques, la plus petite distance entre la structure et chacun des éléments du circuit (120, 220, 320) étant égale à D1, et
un moyen électriquement conducteur (150, 250, 350) relié électriquement à la masse, qui le dispositif comprenant au moins un élément protecteur contre les décharges électrostatiques (140, 240, 340) disposé sur la structure (130, 230, 330) et relié électriquement à celle-ci, **caractérisé en ce que** la plus petite distance entre l'élément protecteur (140, 240, 340) et le moyen électriquement conducteur (150, 250, 350), D2, est inférieure à D1 et non-nulle, sans contact physique entre l'élément protecteur et le moyen électriquement conducteur relié à la masse.

2. Dispositif selon la revendication 1, **caractérisé en ce que** le moyen électriquement conducteur (350) comprend une zone du substrat (310).

3. Dispositif selon la revendication 1, **caractérisé en ce qu'**il comprend une pièce métallique (260) distincte du substrat, dont ledit moyen électriquement conducteur (250) fait partie.

4. Dispositif selon une des revendications 1 à 3, **caractérisé en ce que** l'élément protecteur (140, 240, 340) comprend un matériau métallique, électriquement conducteur.

5. Dispositif selon une des revendications 1 à 4, **caractérisé en ce que** l'élément protecteur (340) est venu de matière avec ladite structure (330).

6. Dispositif selon une des revendications 1 à 4, **caractérisé en ce que** l'élément protecteur (140, 240) est une pièce qui est solidarisée avec ladite structure (130, 230).

7. Dispositif selon une des revendications 1 à 6, **caractérisé en ce que** l'élément protecteur (140, 240, 340) s'étend depuis ladite structure (130, 230, 330) vers le moyen électriquement conducteur (150, 250, 350).

8. Dispositif selon une des revendications 1 à 7, **caractérisée en ce que** le substrat est le substrat d'un circuit imprimé, PCB.

9. Dispositif selon une des revendications 1 à 8, **caractérisé en ce que** le substrat est le substrat d'un dispositif d'interconnexion, MID, à géométrie complexe.

10. Dispositif selon une des revendications 1 à 9, **caractérisé en ce que** le composant électronique est une diode électroluminescente, LED, une diode laser, ou une diode électroluminescente organique, OLED.

11. Dispositif selon une des revendications 1 à 10, **caractérisé en ce que** la structure est un élément de la glace du dispositif lumineux ou une pièce plastique métallisée et susceptible de porter des charges électriques.

12. Dispositif selon une des revendications 1 à 11, **caractérisé en ce que** le dispositif est un feu avant ou un feu arrière d'un véhicule automobile.

## Patentansprüche

1. Leuchtvorrichtung (100, 200, 300) für ein Kraftfahrzeug, die Folgendes umfasst:
ein Substrat (110, 210, 310), auf dem wenigstens ein Element (122, 124; 222, 224; 322, 324) einer elektronischen Schaltung (120, 220, 320), die wenigstens eine für eine elektrostatische Entladung empfindliche elektronische Komponente enthält, angeordnet ist, und
eine Struktur (130, 230, 330), die von dem Substrat verschieden ist und dafür ausgelegt ist, elektrische Ladungen zu tragen, wobei der kleinste Abstand zwischen der Struktur und jedem der Elemente der Schaltung (120, 220, 320) gleich D1 ist, und
ein elektrisch leitendes Mittel (150, 250, 350), das mit Masse elektrisch verbunden ist,
wobei die Vorrichtung wenigstens ein Element (140, 240, 340) für den Schutz vor elektrostatischen Entladungen umfasst, das auf der Struktur (130, 230, 330) angeordnet und damit elektrisch verbunden ist,
**dadurch gekennzeichnet, dass**
der kleinste Abstand D2 zwischen dem Schutzelement (140, 240, 340) und dem elektrisch leitenden Mittel (150, 250, 350) kleiner als D1 und von null verschieden ist, wobei zwischen dem Schutzelement und dem mit Masse verbundenen elektrisch leitenden Mittel kein physikalischer Kontakt vorhanden ist.

2. Vorrichtung nach Anspruch 1, **dadurch gekennzeichnet, dass** das elektrisch leitende Mittel (350) eine Zone (310) des Substrats umfasst.

3. Vorrichtung nach Anspruch 1, **dadurch gekennzeichnet, dass** sie ein von dem Substrat verschiedenes Metallteil (260) umfasst, wovon das elektrisch leitende Mittel (250) einen Teil bildet.

4. Vorrichtung nach einem der Ansprüche 1 bis 3, **dadurch gekennzeichnet, dass** das Schutzelement (140, 240, 340) ein elektrisch leitendes Metallmaterial enthält.

5. Vorrichtung nach einem der Ansprüche 1 bis 4, **dadurch gekennzeichnet, dass** das Schutzelement (340) einteilig mit der Struktur (330) ausgebildet ist.

6. Vorrichtung nach einem der Ansprüche 1 bis 4, **dadurch gekennzeichnet, dass** das Schutzelement (140, 240) ein Teil ist, das mit der Struktur (130, 230) fest verbunden ist.

7. Vorrichtung nach einem der Ansprüche 1 bis 6, **dadurch gekennzeichnet, dass** sich das Schutzelement (140, 240, 340) von der Struktur (130, 230, 330) zu dem elektrisch leitenden Mittel (150, 250, 350) erstreckt.

8. Vorrichtung nach einem der Ansprüche 1 bis 7, **dadurch gekennzeichnet, dass** das Substrat das Substrat einer gedruckten Schaltung, PCB, ist.

9. Vorrichtung nach einem der Ansprüche 1 bis 8, **dadurch gekennzeichnet, dass** das Substrat das Substrat einer Zwischenverbindungsvorrichtung, MID, mit komplexer Geometrie ist.

10. Vorrichtung nach einem der Ansprüche 1 bis 9, **dadurch gekennzeichnet, dass** die elektronische Komponente eine Leuchtdiode, LED, eine Laserdiode oder eine organische Elektrolumineszenzdiode, OLED, ist.

11. Vorrichtung nach einem der Ansprüche 1 bis 10, **dadurch gekennzeichnet, dass** die Struktur ein Element des Glases der Leuchtvorrichtung oder ein metallbeschichtetes Kunststoffteil ist und elektrische Ladungen tragen kann.

12. Vorrichtung nach einem der Ansprüche 1 bis 11, **dadurch gekennzeichnet, dass** die Vorrichtung ein Frontscheinwerfer oder ein Rücklicht eines Kraftfahrzeugs ist.

## Claims

1. Luminous device (100, 200, 300) for a motor vehicle comprising a substrate (110, 210, 310) on which is arranged at least one element (122, 124; 222, 224; 322, 324) of an electronic circuit (120, 220, 320) comprising at least one electronic component sensitive to an electrostatic discharge, and
a structure that is distinct from the substrate (130, 230, 330) capable of carrying electric charge, the smallest distance between the structure and each of the elements of the circuit (120, 220, 320) being equal to D1, and
an electrically conductive means (150, 250, 350) electrically connected to ground,
the device comprising at least one element for protecting against electrostatic discharges (140, 240, 340), which is placed on the structure (130, 230, 330) and electrically connected thereto, **characterized in that**
the smallest distance between the protective element (140, 240, 340) and the electrically conductive means (150, 250, 350), D2, is smaller than D1 and non-zero, without there being physical contact between the protecting element and the electrically conductive means connected to ground.

2. Device according to Claim 1, **characterized in that** the electrically conductive means (350) comprises a region of the substrate (310).

3. Device according to Claim 1, **characterized in that** it comprises a metal part (260) distinct from the substrate, of which said electrically conductive means (250) forms part.

4. Device according to one of Claims 1 to 3, **characterized in that** the protecting element (140, 240, 340) comprises an electrically conductive, metal material.

5. Device according to one of Claims 1 to 4, **characterized in that** the protecting element (340) is made of the same material as said structure (330) .

6. Device according to one of Claims 1 to 4, **characterized in that** the protecting element (140, 240) is a part that is secured to said structure (130, 230).

7. Device according to one of Claims 1 to 6, **characterized in that** the protecting element (140, 240, 340) extends from said structure (130, 230, 330) toward the electrically conductive means (150, 250, 350).

8. Device according to one of Claims 1 to 7, **characterized in that** the substrate is the substrate of a printed circuit board, PCB.

9. Device according to one of Claims 1 to 8, **characterized in that** the substrate is the substrate of a moulded interconnect device of complex geometry.

10. Device according to one of Claims 1 to 9, **characterized in that** the electronic component is a light-emitting diode, LED, a laser diode, or an organic light-emitting diode, OLED.

11. Device according to one of Claims 1 to 10, **characterized in that** the structure is an element of the outer lens of the luminous device or a metal-coated plastic part and capable of carrying electric charge.

12. Device according to one of Claims 1 to 11, **characterized in that** the device is a front light or a rear light of a motor vehicle.
